# EUROPEAN PATENT APPLICATION

(11) **EP 2 469 594 A2**
(43) Date of publication of application: **27.06.2012**
(21) Application number: 11194829.5
(22) Date of filing: 21.12.2011
(51) Int. Cl.: H01L 25/075

(54) **Light emitting module and method of manufacturing the same**

(30) Priority: 21.12.2010 KR 20100131772
(71) Applicant: Samsung LED Co., Ltd., Yongin-City, Gyeonggi-Do (KR)
(72) Inventor: An, Ji Young, Gyeonggi-do (KR)
(74) Representative: Zimmermann & Partner

(57) **Abstract**

There is provided a light emitting module (100) and a method of manufacturing the same. The light emitting module includes a circuit board (101), and a plurality of light emitting devices (102A, 102B) disposed on the circuit board (101), wherein the plurality of light emitting devices (102A, 102B) include at least one light emitting device having a driving voltage less than an average driving voltage of the plurality of light emitting devices (102A, 102B) and at least a further one of light emitting devices adjacent thereto having a driving voltage greater than the average driving voltage. In the light emitting module (100), variations in driving voltages between light emitting modules that may be caused due to driving voltage distribution among the light emitting devices may be minimized.

## Description

This application claims the priority of Korean Patent Application No. 10-2010-0131772 filed on December 21, 2010, in the Korean Intellectual Property Office, the disclosure of which is incorporated herein by reference.

### BACKGROUND OF THE INVENTION

The present invention relates to a light emitting module and a method of manufacturing the same.

A light emitting diode (LED) is a semiconductor device able to emit light of various colors due to electron-hole recombination occurring at a p-n junction when a current is supplied thereto. Such an LED is advantageous over a filament-based light emitting device in that it has a long lifespan, low power usage, superior initial-operation characteristics, and high vibration resistance. These factors have continually boosted the demand for LEDs. Particularly, group III nitride semiconductors that can emit light in the blue/short wavelength region have recently drawn much attention.

Meanwhile, in the case of a light emitting module used as a light source of a liquid crystal display (LCD) backlight unit, a cold cathode fluorescent lamp (CCFL) has conventionally been used. The CCFL employs mercury gas, which may cause environmental pollution. Besides, the CCFL is slow in response rate, low in color reproducibility and inappropriate for a smaller-sized and lighter-weight LCD panel.

In contrast, an LED is environmentally-friendly, has a high response rate in the range of several nanoseconds, is effective for a video signal stream and is thus capable of being impulsively driven. Moreover, the LED can reproduce color by 100% and alter brightness and color temperature by adjusting the amount of light emitted by red, green and blue LEDs. Also, the LED may be advantageously used in the smaller-sized and lighter-weight LCD panel. Therefore, of late, the LED has been actively employed in a light emitting module for a backlight unit

### SUMMARY OF THE INVENTION

According to an aspect of the present invention, there is provided a light emitting module in which variations in driving voltages between light emitting modules that may be caused due to driving voltage dissipation in a light emitting device are minimized.

According to an aspect of the present invention, there is also provided a method of manufacturing the above-stated light emitting module efficiently.

According to an aspect of the present invention, there is provided a light emitting module including: a circuit board; and a plurality of light emitting devices disposed on the circuit board, wherein the plurality of light emitting devices include at least one light emitting device having a driving voltage less than an average driving voltage of the plurality of light emitting devices and at least a further one of the light emitting devices adjacent thereto having a driving voltage greater than the average driving voltage of the plurality of light emitting devices.

The plurality of light emitting devices may have an arrangement in which the at least one light emitting device having the driving voltage less than the average driving voltage and the at least further one light emitting device having the driving voltage greater than the average driving voltage are alternately arranged.

The plurality of light emitting devices may have an arrangement in which two or more light emitting devices having driving voltages less than the average driving voltage and one or more light emitting devices having driving voltages greater than the average driving voltage are alternately arranged.

The plurality of light emitting devices may have an arrangement in which two or more light emitting devices having driving voltages less than the average driving voltage and two or more light emitting devices having driving voltages greater than the average driving voltage are alternately arranged.

The circuit board may have a bar shape, and the plurality of light emitting devices may be arranged in a lengthwise direction of the circuit board.

According to another aspect of the present invention, there is provided a method of manufacturing a light emitting module, the method including: preparing a light emitting device group including a plurality of light emitting devices; dividing the plurality of light emitting devices included in the light emitting device group into two or more subgroups according to driving voltages thereof; and alternately arranging at least one or more light emitting devices respectively selected from the two or more subgroups on the circuit board.

The driving voltages of the plurality of light emitting devices included in the light emitting device group may have normal distribution.

The plurality of light emitting devices may be divided into two subgroups based on an average value of the driving voltages of the plurality of light emitting devices.

The plurality of light emitting devices may be divided into three subgroups based on a voltage value less than an average value of the driving voltages of the plurality of light emitting devices and a voltage value greater than the average value thereof.

An average value of the normal distribution may be identical to an average value of the driving voltages of the plurality of light emitting devices.

The alternate arranging of at least one or more light emitting devices respectively selected from the two or more subgroups on the circuit board may include allowing two or more light emitting devices belonging to the same subgroup to be arranged adjacent to each other in at least part of the circuit board.

### BRIEF DESCRIPTION OF THE DRAWINGS

The above and other aspects, features and other advantages of the present invention will be more clearly understood from the following detailed description taken in conjunction with the accompanying drawings, in which:

FIG. 1 is a schematic plan view illustrating a light emitting module according to an exemplary embodiment of the present invention;

FIG. 2 is a schematic perspective view illustrating a light emitting module according to an exemplary embodiment of the present invention;

FIGS. 3 and 5 are graphs illustrating the distribution of light emitting devices according to driving voltages;

FIG. 4 is a schematic plan view illustrating a light emitting module according to another exemplary embodiment of the present invention; and

FIGS. 6 through 8 are schematic plan views illustrating a backlight unit according to another exemplary embodiment of the present invention.

### DETAILED DESCRIPTION OF THE PREFERRED EMBODIMENT

Exemplary embodiments of the present invention will now be described in detail with reference to the accompanying drawings.

The invention may, however, be embodied in many different forms and should not be construed as being limited to the embodiments set forth herein. Rather, these embodiments are provided so that this disclosure will be thorough and complete, and will fully convey the scope of the invention to those skilled in the art. In the drawings, the shapes and dimensions of elements may be exaggerated for clarity, and the same reference numerals will be used throughout to designate the same or like elements.

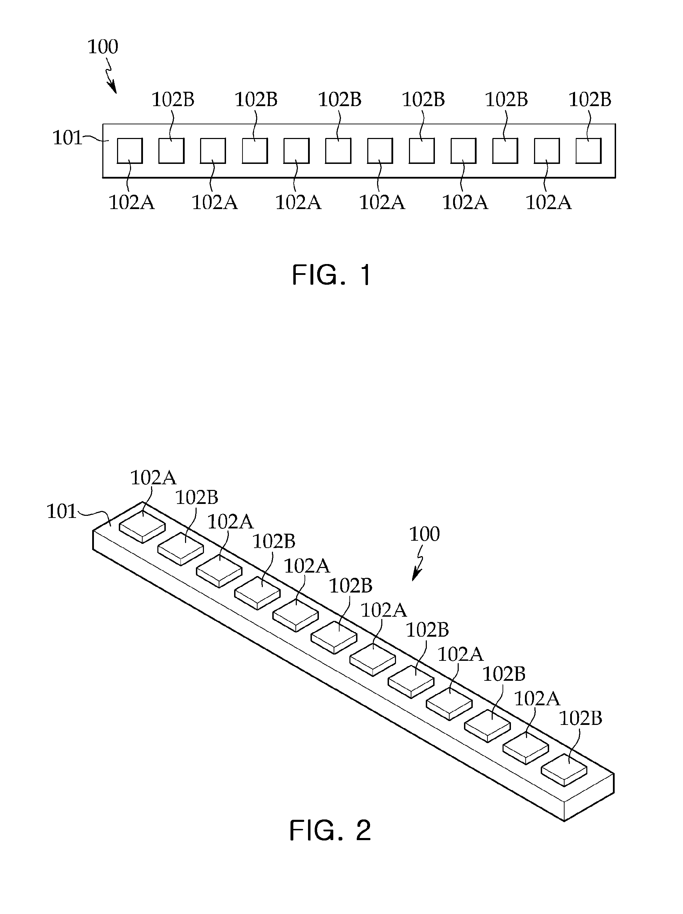

FIGS. 1 and 2 illustrate a light emitting module according to an exemplary embodiment of the present invention. FIG. 1 is a schematic plan view of the light emitting module as viewed from above, and FIG. 2 is a schematic perspective view of the light emitting module. With reference to FIGS. 1 and 2, a light emitting module 100 according to an exemplary embodiment of the invention includes a circuit board 101 and a plurality of light emitting devices 102A and 102B. Although not shown, the light emitting module 100 may further include a connector for the reception and transmission of electrical signals from and to an external power source. The circuit board 101 may be elongated in a lengthwise direction, that is, the circuit board 101 may have a bar shape. A circuit board used in the art to which the present invention pertains may be used. For example, a PCB, an MCPCB, an MPCB, an FPCB or the like may be used. Here, the circuit board 101 may have a wiring pattern (not shown) on a surface thereof and in an inner portion thereof. The wiring pattern may be electrically connected to the light emitting devices 102A and 102B.

The light emitting devices 102A and 102B may employ any device able to emit light when an electrical signal is applied thereto. A light emitting diode (LED) may be used therefor. In the present embodiment, the plurality of light emitting devices 102A and 102B are provided and they are electrically connected to each other. In addition, in a case in which the circuit board 101 has a bar shape, as shown in FIG. 1, the plurality of light emitting devices 102A and 102B may be arrayed in a lengthwise direction of the circuit board 101. In this case, the light emitting devices 102A and 102B may be manufactured as chips and mounted on the circuit board 101, as a so-called 'chip-on-board' (COB) structure, or may be manufactured as packages and mounted thereon. However, a method of mounting the light emitting devices 102A and 102B is not particularly limited. Although not shown, the light emitting devices 102A and 102B may be connected to the wiring pattern of the circuit board 101 in various manners, for example, in a wired manner using a conductive wire or in a flip chip bonding manner.

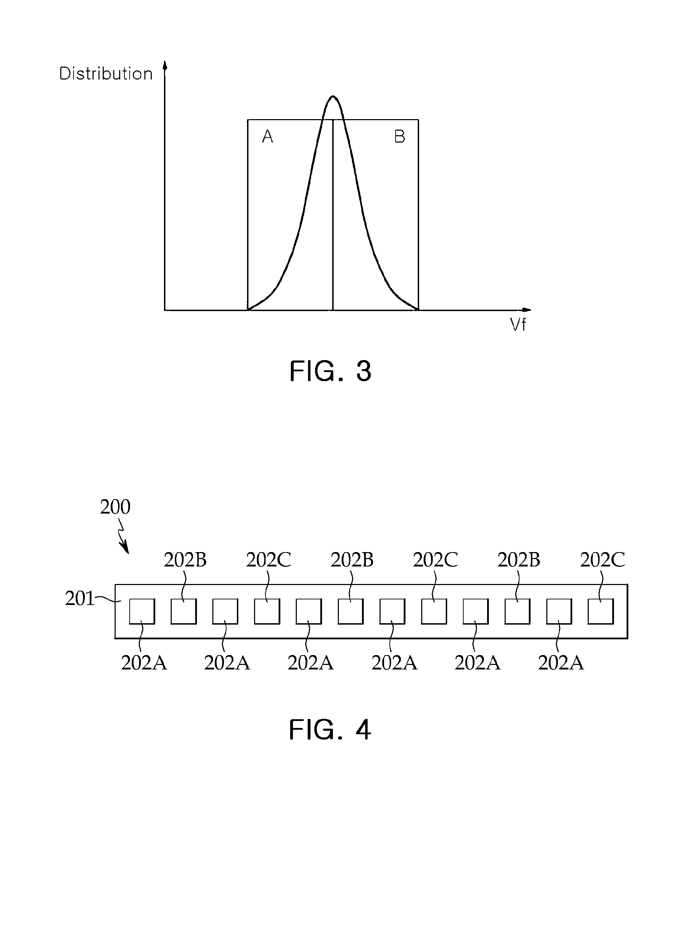

In the present embodiment, the plurality of light emitting devices 102A and 102B may have different driving voltages, i.e., different forward voltage characteristics. More particularly, the light emitting devices 102A and 102B having different driving voltages are alternately arranged on the circuit board 101. A process of manufacturing the light emitting module 100 by arranging the light emitting devices 102A and 102B according to driving voltages will be described with reference to FIG. 3 in detail. FIG. 3 is a graph illustrating the distribution of light emitting devices according to driving voltages. A plurality of light emitting devices is manufactured before being mounted on the circuit board 101. Among them, an appropriate number of light emitting devices are selected and mounted on the circuit board 101. In the present embodiment, twelve light emitting devices are selected and mounted on the circuit board 101. The plurality of light emitting devices have different driving voltages and have driving voltage distribution similar to normal distribution as shown in FIG. 3. In the case of a light emitting module manufactured by randomly selecting light emitting devices in the normal distribution, it may have a high driving voltage variation as compared with other light emitting modules. For example, in the case that individual light emitting modules are manufactured by randomly selecting twelve light emitting devices having driving voltage distribution in which an average driving voltage of the individual light emitting devices is 3V and the minimum and maximum driving voltages thereof are 2V and 4V, respectively, the average driving voltage of the individual light emitting modules is approximately 36V and the minimum and maximum driving voltages thereof are approximately 32V and 40V, respectively. Accordingly, variations in the driving voltages between the light emitting modules may be approximately 8V.

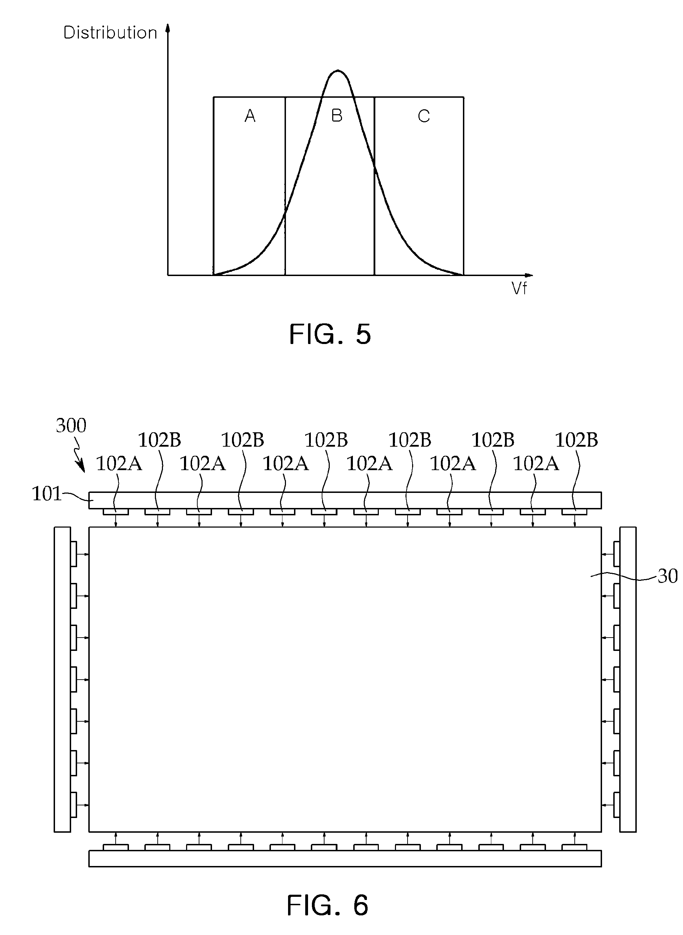

According to the present embodiment, in order to minimize such variations in the driving voltages between the light emitting modules, the plurality of light emitting devices prior to being mounted are divided into two or more subgroups according to the driving voltages thereof. In the exemplary embodiment shown in FIGS. 1 through 3, the plurality of light emitting devices is divided into two subgroups. That is, the plurality of light emitting devices 102A and 102B having the normal distribution are divided into two subgroups A and B on the basis of the average driving voltage thereof in the normal distribution, and the light emitting devices 102A and 102B included in the respective subgroups A and B are alternately disposed. The light emitting modules manufactured in this manner may have a reduction in driving voltage variations therebetween. For example, in the case in which the individual light emitting modules 100 are manufactured in a manner such that the light emitting devices 102A having driving voltages ranging from 2V to 3V belong to subgroup A and the light emitting devices 102B having driving voltages ranging from 3V to 4V belong to subgroup B on the basis of the average driving voltage of 3V, the average driving voltage of the individual light emitting modules is approximately 36V and the minimum and maximum driving voltages thereof are approximately 33V and 39V, respectively. Accordingly, variations in the driving voltages between the light emitting modules can be reduced to approximately 6V. That is, as compared with the above-described light emitting modules in which the light emitting devices are not divided into the subgroups on the basis of the driving voltages thereof, that is, the light emitting devices are randomly selected, the average driving voltage of the individual light emitting modules is identical, but the variations in the driving voltages between the light emitting modules may be reduced by approximately 2V. Accordingly, a backlight unit (see FIGS. 6 to 8), a lighting apparatus or the like, including the plurality of light emitting modules 100 may achieve uniformity in the brightness of the individual light emitting modules 100. In addition, the magnitude of current applied to a circuit for driving the light emitting modules 100 may be reduced to thereby achieve a reduction in power consumption.

As described above, in the case of the light emitting module 100 according to the present embodiment, a light emitting device group having normal voltage distribution is divided into the two subgroups A and B and the light emitting devices 102A and 102B respectively selected from the two subgroups A and B are alternately arranged. In this arrangement, as compared with the average value of the driving voltages of the plurality of light emitting devices 102A and 102B, i.e., the value obtained by dividing the sum of the driving voltages of twelve light emitting devices 102A and 102B by the number of the light emitting devices (the average driving voltage of the light emitting module), the driving voltage of a first light emitting device 102A is less than the average driving voltage of the light emitting module and the driving voltage of a second light emitting device 102B is greater than the average driving voltage of the light emitting module.

Meanwhile, in the present embodiment, the light emitting devices 102A and 102B, selected from the different subgroups A and B, are alternately disposed one by one, and this arrangement may be advantageous in terms of the uniformity of brightness within the light emitting module 100; however, the present invention is not limited thereto. That is, according to necessity, the light emitting devices 102A and 102B, selected from the different subgroups A and B, may be alternately disposed in pairs, i.e., AABBAABB..., by way of example. Also, in the present embodiment, while the subgroups A and B are divided on the basis of the average value of the driving voltages in the normal distribution, it should not be necessary to divide the subgroups A and B on the basis of the average value of the driving voltages thereof. In another exemplary embodiment, values other than the average value of the driving voltages may be selected in determining the division of the subgroups.

FIG. 4 is a schematic plan view illustrating a light emitting module according to another exemplary embodiment of the present invention. FIG. 5 is a graph illustrating the distribution of light emitting devices according to driving voltages. With reference to FIG. 4, a light emitting module 200 according to this embodiment includes a circuit board 201 and a plurality of light emitting devices 202A, 202B and 202C. In the present embodiment, as shown in FIG. 5, the plurality of light emitting devices 202A, 202B and 202C are divided into three subgroups A, B and C according to driving voltages in normal distribution, and the plurality of light emitting devices 202A, 202B and 202C, respectively selected from the respective subgroups A, B and C, are used to form the light emitting module 200. In the light emitting module 200, for example, the light emitting devices 102A having driving voltages ranging from 2V to 2. 7V belong to subgroup A, the light emitting devices 102B having driving voltages ranging from 2. 7V to 3.3V belong to subgroup B, and the light emitting devices 102C having driving voltages ranging from 3.3V to 4.0V belong to subgroup C. In the case that the individual light emitting modules 200 are manufactured by selecting the light emitting devices from the respective three subgroups A, B and C and disposing them in an ABACABAC... arrangement, the average driving voltage of the individual light emitting modules 200 is approximately 36V and the minimum and maximum driving voltages thereof are approximately 33V and 38V, respectively. Accordingly, variations in the driving voltages between the light emitting modules may be reduced to approximately 5V. That is, as compared with the above-described light emitting modules in which the light emitting devices are not divided into the subgroups on the basis of the driving voltages thereof, the average driving voltage of the individual light emitting modules 200 is identical, but the driving voltage variations between the light emitting modules 200 may be further reduced by approximately 3V.

Meanwhile, in the present embodiment, the ABACABAC... arrangement is used. However, the arrangement of the light emitting devices divided into the three subgroups A, B and C may be variously modified. For example, an ABAB... arrangement, a BCBC... arrangement or the like may be used. Also, two or more light emitting devices selected from at least one of the subgroups A, B and C may be successively arranged (e. g., an ABBC... arrangement).

The light emitting modules obtained in the above-described manner may be applicable to a wide variety of devices such as a backlight unit, a lighting apparatus, or the like. In a case in which the light emitting modules are used in a backlight unit, FIGS. 6 through 8 are schematic plan views illustrating a backlight unit according to another exemplary embodiment of the present invention. A backlight unit 300 of FIG. 6 includes the four light emitting modules as shown in the embodiment of FIG. 1 and each of the four light emitting modules is disposed on respective side surfaces of a light guide plate 301 to emit light to the light guide plate 301, which is a so-called edge-type or side-view type backlight unit. In this case, although not shown, there may be provided a driver connected to the light emitting modules and adjusting the brightness of the light emitting modules. The driver may be individually connected to the light emitting modules or may adjust the brightness of two or more light emitting modules at the same time.

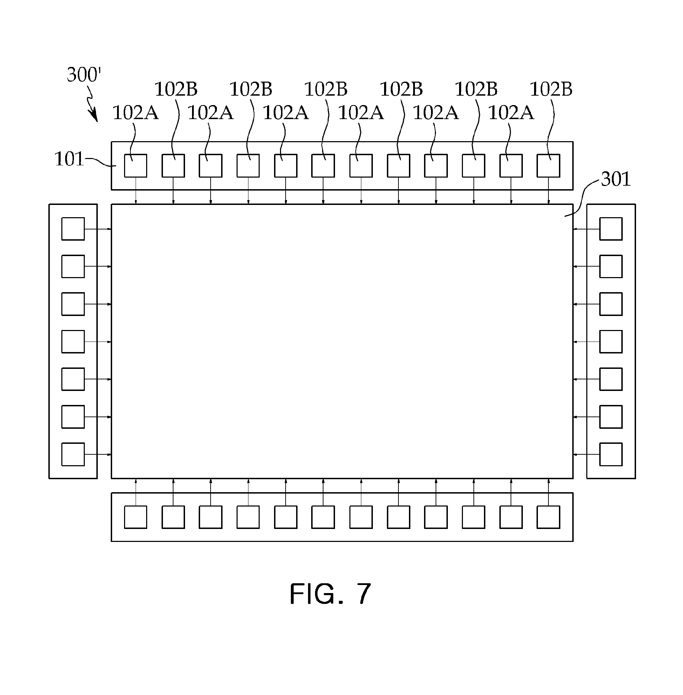

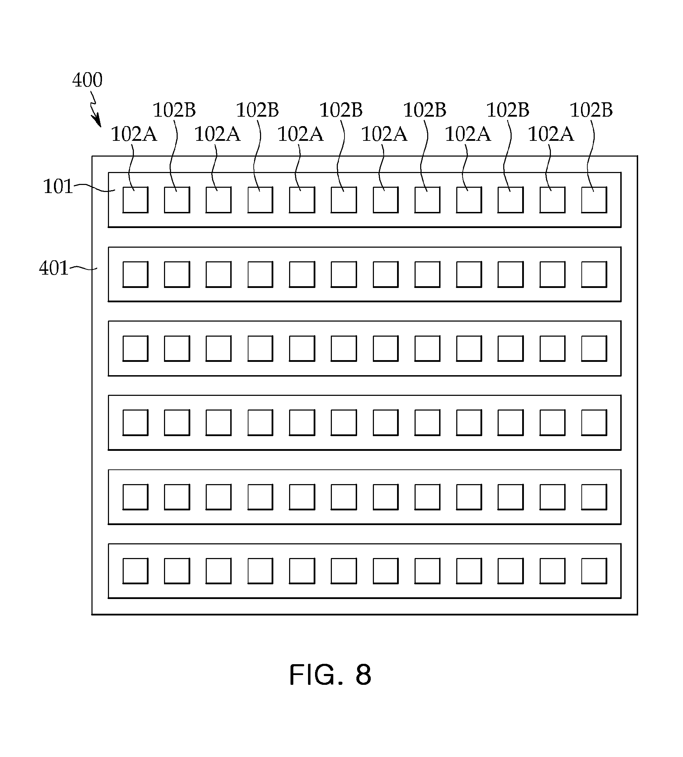

As described above, the light emitting modules are manufactured by selectively dividing the light emitting devices into the subgroups according to the magnitude of driving voltages, and thus a driving voltage variation between light emitting modules may be minimized. In the case of the backlight unit 300 using a plurality of light emitting modules as described in the present embodiment, the overall brightness thereof becomes uniform and the power consumption thereof may be lowered by reducing the magnitude of current applied to a driving circuit. In this embodiment, the light emitting modules each having an ABAB arrangement as shown in FIG. 1 are employed in the backlight unit 300. However, light emitting modules having different arrangements as described with reference to FIG. 4 may be used. This may also be applied to a backlight unit of FIGS. 7 and 8.

Meanwhile, in the embodiment of FIG. 6, light is emitted from the upper surfaces of the light emitting devices 102A and 102B. However, the arrangement of the circuit board 101 may be modified. Specifically, as shown in a backlight unit 300' according to a modified exemplary embodiment of FIG. 7, the circuit board 101 may be disposed such that the side surfaces of the light emitting devices 102A and 102B may be the main light emitting surfaces. Also, an edge-type backlight unit is described in the embodiments of FIGS. 6 and 7, but a direct-type or top-view type backlight unit 400 may be used as shown in the embodiment of FIG. 8. That is, a plurality of light emitting modules may be mounted on a unit board 401 to thereby allow light to be emitted upwardly of the unit board 401.

As set forth above, according to exemplary embodiments of the invention, there is provided a light emitting module in which variations in driving voltages between light emitting modules that may be caused due to driving voltage distribution among the light emitting devices may be minimized.

In addition, there is provided a method of manufacturing the above-stated light emitting module efficiently.

While the present invention has been shown and described in connection with the exemplary embodiments, it will be apparent to those skilled in the art that modifications and variations can be made without departing from the scope of the invention as defined by the appended claims.

## Claims

1. A light emitting module comprising:
a circuit board (101, 201); and
a plurality of light emitting devices (102A, 102B, 201A, 202B, 203C) disposed on the circuit board (101, 201),
wherein the plurality of light emitting devices (102A, 102B, 201A, 202B, 203C) include at least one light emitting device having a driving voltage less than an average driving Voltage of the plurality of light emitting devices (102A, 102B, 201A, 202B, 203C) and at least a further one of light emitting devices adjacent thereto having a driving Voltage greater than the average driving Voltage of the plurality of light emitting devices.

2. The light emitting module of claim 1, wherein the plurality of light emitting devices (102A, 102B, 201A, 202B, 203C) has an arrangement in which the at least one light emitting device having the driving Voltage less than the average driving voltage and the at least further one light emitting device having the driving voltage greater than the average driving voltage are alternately arranged.

3. The light emitting module of claim 1 or 2, wherein the plurality of light emitting devices (102A, 102B, 201A, 202B, 203C) has an arrangement in which two or more light emitting devices having driving voltages less than the average driving voltage and one or more light emitting devices having driving voltages greater than the average driving voltage are alternately arranged.

4. The light emitting module of any one of the claims 1 to 3, wherein the plurality of light emitting devices (102A, 102B, 201A, 202B, 203C) has an arrangement in which two or more light emitting devices having driving voltages less than the average driving Voltage and two or more light emitting devices having driving voltages greater than the average driving voltage are alternately arranged.

5. The light emitting module of any one of the claims 1 to 4, wherein the circuit board (101, 201) has a bar shape, and
the plurality of light emitting devices (102A, 102B, 201A, 202B, 203C) is arranged in a lengthwise direction of the circuit board (101, 201).

6. A method of manufacturing a light emitting module, the method comprising:
preparing a light emitting device group including a plurality of light emitting devices (102A, 102B, 201A, 202B, 203C);
dividing the plurality of light emitting devices (102A, 102B, 201A, 202B, 203C) included in the light emitting device group into two or more subgroups (A, B, C) according to driving voltages thereof; and
alternately arranging at least one or more light emitting devices (102A, 102B, 201A, 202B, 203C) respectively selected from the two or more subgroups (A, B, C) on a circuit board (101, 201).

7. The method of claim 6, wherein the driving voltages of the plurality of light emitting devices (102A, 102B, 201A, 202B, 203C) included in the light emitting device group have normal distribution.

8. The method of claim 7, wherein the plurality of light emitting devices (102A, 102B, 201A, 202B, 203C) is divided into two subgroups based on an average value of the driving voltages of the plurality of light emitting devices.

9. The method of claim 7 or 8, wherein the plurality of light emitting devices (102A, 102B, 201A, 202B, 203C) are divided into three subgroups based on a Voltage value less than an average value of the driving voltages of the plurality of light emitting devices and a voltage value greater than the average value thereof.

10. The method of any of the claims 7 to 9, wherein an average value of the normal distribution is identical to an average value of the driving voltages of the plurality of light emitting devices.

11. The method of any one of the claims 6 to 10, wherein the alternate arranging of at least one or more light emitting devices respectively selected from the two or more subgroups (A, B, C) on the circuit board (101, 201) includes allowing two or more light emitting devices belonging to the same subgroup to be arranged adjacent to each other in at least part of the circuit board.
